(19) Europäisches Patentamt

European Patent Office

Office européen des brevets

(11) **EP 1 493 719 A1**

(12) **EUROPEAN PATENT APPLICATION**
published in accordance with Art. 158(3) EPC

(43) Date of publication:
05.01.2005 Bulletin 2005/01

(51) Int Cl.⁷: **C03C 3/06**, C03B 20/00

(21) Application number: 03715446.5

(22) Date of filing: 26.03.2003

(86) International application number:
PCT/JP2003/003759

(87) International publication number:
WO 2003/080526 (02.10.2003 Gazette 2003/40)

(84) Designated Contracting States:
AT BE BG CH CY CZ DE DK EE ES FI FR GB GR HU IE IT LI LU MC NL PT RO SE SI SK TR

(30) Priority: 27.03.2002 JP 2002089667

(71) Applicants:
- **Japan Science and Technology Agency**
Kawaguchi-shi, Saitama 332-0012 (JP)
- **Asahi Glass Co., Ltd.**
Tokyo 100-8306 (JP)

(72) Inventors:
- **HOSONO, Hideo**
Yamato-shi, Kanagawa 242-0001 (JP)
- **KAJIHARA, Kouichi**
Kawasaki-shi, Kanagawa 213-0011 (JP)
- **HIRANO, Masahiro**
Setagaya-ku, Tokyo 156-0043 (JP)
- **IKUTA, Yoshiaki**
Koriyama-shi, Fukushima 963-8025 (JP)
- **KIKUKAWA, Shinya**
Yokohama-shi, Kanagawa 236-0057 (JP)

(74) Representative: **Wagner, Karl H., Dipl.-Ing.**
Wagner & Geyer,
Patentanwälte,
Gewürzmühlstrasse 5
80538 München (DE)

(54) **SYNTHETIC QUARTZ GLASS**

(57) Disclosed is a synthetic silica glass for use with light having a wavelength of 150 to 200 nm, which has an OH group at a concentration of less than 1 ppm, an oxygen-excess type defect at a concentration of $1 \times 10^{16}$ defects/cm³ or less, a hydrogen molecule at a concentration of less than $1 \times 10^{17}$ molecules/cm³, and a non-bridging oxygen radical at a concentration of $1 \times 10^{16}$ radicals/cm³ or less in the state after the synthetic silica glass is irradiated with light of a xenon excimer lamp having an energy density of 10 mW/cm² and 3 kJ/cm² or with light of an $F_2$ laser by $10^7$ pulses at an energy density of 10 mJ/cm²/pulse. The synthetic silica glass can exhibit excellent resistance to ultraviolet light with a wavelength of 150 to 190 nm when incorporated in a device using ultraviolet light with a wavelength of 150 to 190 nm as a light source.

EP 1 493 719 A1

**Description**

TECHNICAL FIELD

The present invention relates to a synthetic silica glass for optical components to be used for ultraviolet light source with a wavelength of 150 to 200nm, and a production method therefore. More specifically, the present invention relates to a synthetic silica glass for optical components, such as lens, prism, photomask, window or pellicle, compatible for vacuum-ultraviolet to ultraviolet light from an ArF excimer laser (193 nm), a $F_2$ laser (157 nm), a low-pressure mercury lamp (185 nm) or a excimer lamp (Xe-Xe: 172 nm).

BACKGROUND ART

A synthetic silica glass has various features, including optical transparency over a wide wavelength range from near-infrared to vacuum-ultraviolet light, excellent dimensional size stability based on extremely small thermal expansion coefficient, and high purity almost free from metal impurities. In view of these features, the synthetic silica glass has been extensively used as optical components in optical device for conventional g- or i-lines of a light source.

In recent years, in connection with advances in large-scale integration circuits (LSI), optical lithography technologies for fabricating an integrated circuit on a wafer have been required to realize fine patterns with a narrower line width. In order to cope with this need, the developments of an exposure light source emitting sorter wavelengths are being promoted. For example, as a light source for lithography steppers an ArF excimer laser or a $F_2$ laser is to be used in place of the conventional g-line (436 nm) and i-line (365 nm).

Further, a low-pressure mercury lamp (185 nm) and an excimer lamp (Xe-Xe: 172 nm) are used in light enhanced CVD apparatus, silicon-wafer washing apparatus, ozone generators, etc., and attempts in applying them to optical lithography technologies are being made. Synthetic silica glass is also used for a gas-filled tube for the low-pressure mercury lamp, and the excimer lamp or optical components for the above-mentioned optical equipment used for short-wavelength light sources. The synthetic silica glass for these optical apparatus is required to maintain optical transparency in the wavelength range of ultraviolet to the vacuum-ultraviolet regions and to have a characteristic in which no deterioration of transmittance when a working wavelength of light is irradiated (hereinafter referred to as "ultraviolet-light resistance").

However, when a conventional synthetic silica glass is irradiated with light from a high-energy light source, such as ArF excimer laser or a $F_2$ laser, a new absorption band is induced in the ultraviolet wavelength region to cause deterioration of transmittance in a working wavelength range, resulting in poor ultraviolet-light resistance as optical components to be used in optical apparatus using an ArF excimer laser or a $F_2$ laser as a light source.

More specifically, it is known that the irradiation with ultraviolet light, such as ArF excimer laser or $F_2$ laser, for a long period of time, induces absorption bands having a center wavelength of 214 nm, so-called E' center ($\equiv$ Si ·) (hereinafter referred to as "214 nm absorption band"), and an absorption band having a center wavelength of 260 nm, so-called NBOHC (non-bridging oxygen hole center or non-bridging oxygen radical: $\equiv$ Si - O ·) (hereinafter referred to as "260 nm absorption band"). These absorption bands lead to deterioration of optical transmittance over a wide wavelength range of 190 to 280 nm. Moreover, through the long-time irradiation with ultraviolet light, the optical transmittance is further deteriorated in the wavelength range of 155 to 190 nm apart from the wavelength centers of the above-mentioned absorption bands, resulting in the poor ultraviolet-light resistance as optical components used for optical devices for a light source having the above wavelength range.

Recently, there has been made an invention relating to a synthetic silica glass which has an OH group at a concentration of 10 ppm or less, a hydrogen molecule at a concentration of less than $1 \times 10^{17}$ molecules/cm$^3$, and substantially no reduction type defect, wherein the variation in absorption coefficient in the wavelength range of 150 to 200 nm is 0.2 cm or less even after the synthetic silica glass is irradiated with ultraviolet light having a wavelength of 172 nm with an energy density of 10 mW/cm$^2$ or 10 kJ/cm$^2$ (Japanese Patent Laid-Open Publication No. 2001-180962).

DISCLOSURE OF INVENTION

It is an object of the present invention to provide a synthetic silica glass capable of exhibiting excellent resistance to ultraviolet light with a wavelength of 150 to 190 nm when incorporated in a device using ultraviolet light with a wavelength of 150 to 190 nm as a light source.

Through intensive analytical researches on ultraviolet-light resistance, the inventors had novel knowledge that an absorption band having a center wavelength of 180 nm due to NBOHC (hereinafter refereed to as "180 nm absorption band") exists as one of the absorption bands created in a synthetic silica glass in addition to the 214 nm absorption band and the 260 nm absorption band. The inventors also found that the deterioration of optical transmittance in the wavelength range of 150 to 190 as the result of the irradiation with ultraviolet light is attributable mainly to the generation of NBOHC, and can be suppressed only if the concentration of NBOHC to be generated is reduced to a given value or less, specifically by controlling each of the concentrations of OH group and oxygen-excess type defect ($\equiv$ Si - O - O - Si $\equiv$) in the synthetic silica glass at a given value.

Specifically, the present invention provides a synthetic silica glass for use with light having a wavelength of 150 to 200 nm, which has an OH group at a concentration of less than 1 ppm, an oxygen-excess type defect at a concentration of $1 \times 10^{16}$ defects/cm$^3$ or less, a hydrogen molecule at a concentration of less than $1 \times 10^{17}$ molecules/cm$^3$, and a non-bridging oxygen radical at a concentration of $1 \times 10^{16}$ radicals/cm$^3$ or less in the state after the synthetic silica glass is irradiated with light of a xenon excimer lamp having an irradiance of 10 mW/cm$^2$ and 3 kJ/cm$^2$.

The present invention further provides a synthetic silica glass for use with light having a wavelength of 150 to 200 nm, which has an OH group at a concentration of less than 1 ppm, an oxygen-excess type defect at a concentration of $1 \times 10^{16}$ defects/cm$^3$ or less, a hydrogen molecule at a concentration of less than $1 \times 10^{17}$ molecules/cm$^3$, and a non-bridging oxygen radical at a concentration of $1 \times 10^{16}$ radicals/cm$^3$ or less in the state after the synthetic silica glass is irradiated with light of an F$_2$ laser by 10$^7$ pulses at an energy density of 10 mJ/cm$^2$/pulse.

The relationship between the concentration of NBOHC: $C_{NBOHC}$ (radicals/cm$^3$), and a 180 nm absorption coefficient $\alpha_{180}$ (cm$^{-1}$) is derived by the following formula (1):

$$C_{NBOHC} \text{ (radicals/cm}^3\text{)} = 2.4 \times 10^{17} \times \alpha_{180} \text{ (cm}^{-1}\text{)} \qquad (1)$$

Thus, if the concentration of NBOHC is reduced to $1 \times 10^{16}$ radicals/cm$^3$ or less, the generation of the 180 nm absorption band can be suppressed to obtain excellent ultraviolet-light resistance.

The OH group in the synthetic silica glass is transformed to NBOHC by the irradiation with ultraviolet light according to the following formula (2) to not only cause deterioration of ultraviolet-light resistance but also have adverse affect on initial optical transmittance. Thus, it is desired to minimize the concentration of OH group in the synthetic silica glass. Specifically, the concentration of OH group is preferably set at 1 ppm or less.

$$\equiv \text{Si - OH} + h\nu \rightarrow \equiv \text{Si} — \text{O} \cdot + \cdot \text{H} \qquad (2)$$

The oxygen-excess type defect in the synthetic silica glass means the structure of $\equiv$ Si -O-O-Si$\equiv$. As with the OH group, the oxygen-excess type defect is transformed to NBOHC by the irradiation with ultraviolet light according to the following formula (3) to cause deterioration of ultraviolet-light resistance. Thus, it is desired to minimize the concentration of oxygen-excess type defect in the synthetic silica glass. Specifically, the concentration of oxygen-excess type defect is preferably set at $1 \times 10^{16}$ defects/cm$^3$ or less.

$$\equiv \text{Si-O-O-Si} \equiv + h\nu \rightarrow 2 \equiv \text{Si-O} \cdot \qquad (3)$$

The concentration of oxygen-excess type defect in the synthetic silica glass can be evaluated by subjecting the synthetic silica glass to a thermal treatment in a hydrogen-containing atmosphere so as to substituting the oxygen-excess type defect with a SiOH group. A specific evaluation process will be described below. A synthetic silica glass sample having a thickness of 10 mm is held under a 100 % hydrogen-gas atmosphere of 1 atm at a temperature of 1000°C for 50 hours. Before and after this treatment, measurements using an infrared spectrophotometer are performed to determine the variation $\Delta$OH (weight ppm) in the concentration of OH group based on an absorption peak-intensity at a wavelength of 2.7 µm (Cer. Bull., 55 (5), 524, (1976)) and calculate the concentration of oxygen-excess type defect: $C_{POL}$ (defects/cm$^3$), according to the following formula (4):

$$C_{POL} \text{ (defects/cm}^3\text{)} = 3.68 \times 10^{16} \times \Delta\text{OH (weight ppm)} \qquad (4)$$

The concentration of hydrogen molecule in the synthetic silica glass of the present invention is preferably set at $1 \times 10^{17}$ molecules/cm$^3$ or less. If the concentration of hydrogen molecule in the synthetic silica glass is greater than $1 \times 10^{17}$ molecules/cm$^3$, an oxygen-deficit type (reduction type) defect will be generated by the irradiation with ultraviolet light. The defect having an optical absorption band with a center wavelength of 163 nm causes significant deterioration of ultraviolet-light resistance.

In addition, the oxygen-deficit type defect ($\equiv$ Si - Si $\equiv$) in the synthetic silica glass having the optical absorption band with a center wavelength of 163 nm undesirably causes deterioration of initial optical transmittance. Specifically, the concentration of oxygen-deficit type defect is preferable set at $1 \times 10^{14}$ defects/cm$^3$ or less.

In the present invention, metal impurities (alkali metal, alkali earth metal, transition metal, etc.) and chlorine in the synthetic silica glass causes not only deterioration of transmittance in vacuum-ultraviolet to ultraviolet wavelength ranges but also deterioration of ultraviolet-light resistance. Thus, it is desired to minimize the contents of metal impurities and chlorine. The content of metal impurities is preferably 100 ppb or less, particularly 10 ppb or less. The content of chlorine is preferably 100 ppm or less, more preferably 10 ppm or less, particularly 1 ppm or less.

The optical synthetic silica glass of the present invention may be prepared through a direct synthesis method, a soot deposition method (VAD process, OVD process) or a plasma process. In particular, the soot deposition method is preferable because it can control the concentration of OH group in the synthetic silica glass relatively readily and perform a synthetic process at a relatively low temperature to advantageously avoid the incorporation of chlorine and metal purities.

BEST MODE FOR CARRYING OUT THE INVENTION

[Inventive Examples & Comparative Examples]

Hexamethyldisilazane used as a row material was hydrolyzed in an oxyhydrogen flame to form fine silica particles, and the obtained silica particles were deposited on a substrate to prepare a porous silica glass body (diameter: 300 mm, length: 600 mm). This porous silica glass body was placed in an electric furnace capable of controlling atmosphere, and heated up to a temperature of 1450°C under an atmosphere as shown in Table 1 to obtain a transparent silica glass body (diameter: 200 mm, length: 300 mm).

A sample (diameter: 200 mm, length: 20 mm) was cut out from the central region of the obtained transparent silica glass body, and subjected to a post-treatment under the conditions as shown in Table 1. Further, several samples of 20 mm □ × 10 mm thickness and several samples of 20 mm □ × 30 mm thickness were cut out from the central region of the transparent silica glass body, and two surfaces of 20 mm □ were mirror-polished to prepared evaluation samples.

Each of evaluations was performed using the evaluation samples.

[Concentration of OH group]

The sample of 10 mm thickness was measured using an infrared spectrophotometer to determine the concentration of OH group based on an absorption peak at a wavelength of 2.7 μm (Cer. Bull., 55 (5), 524, (1976)). A detection limit in this process is 0.1 weight ppm.

[Concentration of Hydrogen Molecule]

The sample of 10 mm thickness was subjected to a Raman Scattering analysis to calculate the concentration of hydrogen molecule (molecules/cm$^3$) based on the intensity ratio (= $I_{4160}/I_{800}$) of an intensity $I_{4160}$ detected based on a scattering peak at 4135 cm$^{-1}$ to a scattering peak intensity $I_{800}$ at 800 cm$^{-1}$ which is a fundamental vibration of silicon - oxygen bond, in a Raman spectrum (V. S. Khotimchenko, et al., Zhurnal Prikladnoi Spektroskopii, Vol. 46, No. 6, pp. 987-997, 1986). A detection limit in this process is $3 \times 10^{16}$ molecules/cm$^3$.

[Concentration of Oxygen-Excess Type Defect]

The sample of 10 mm thickness was held under a 100% hydrogen-gas atmosphere of 1 atm at a temperature of 1000°C for 50 hours. Before and after this treatment, measurements using an infrared spectrophotometer were performed to determine the variation ΔOH (weight ppm) in the concentration of OH group based on an absorption peak-intensity at a wavelength of 2.7 μm (Cer. Bull., 55 (5), 524, (1976)) and calculate the concentration of oxygen-excess type defect: $C_{POL}$ (defects/cm$^3$), according to the formula (4). A detection limit in this process is $1 \times 10^{16}$ defects/cm$^3$.

[Concentration of Oxygen-Deficit Type Defect]

The respective transmittances of the sample of 10 mm thickness and the sample of 30 mm thickness at a wavelength of 163 nm were measured using a vacuum-ultraviolet spectrophotometer (VTMS 502: Acton Research Co.), and the concentration of oxygen-deficit type defect: $C_{ODC}$ (defects/cm$^3$), was calculated according to the following formula (5):

$$C_{ODC} = 4.5 \times 10^{15} \times 1n \ (T_{10}/T_{30}) \tag{5},$$

wherein $T_{10}$ is a transmittance (%) of the sample of 10 mm thickness at a wavelength of 163 nm, and $T_{30}$ a transmittance (%) of the sample of 30 mm thickness at a wavelength of 163 nm.

A detection limit in this process is $1 \times 10^{14}$ defects/cm$^3$.

[Initial Transmittance & Light Resistance]

The sample of 10 mm thickness was irradiated with light of a xenon excimer lamp (center wavelength: 172 nm, energy density: 10 mW/cm$^2$) for 100 hours, and the respective transmittances of the sample before and after the irradiation were measured using a vacuum-ultraviolet spectrophotometer (VTMS 502: Acton Research Co.) and an ultraviolet spectrophotometer (U 4000: Hitachi, Ltd.) to evaluate the respective initial transmittance before and after the irradiation at a wavelength of 172 nm.

Further, ultraviolet-light-irradiation-induced absorption coefficient $\Delta\alpha$ ($\lambda$) in the wavelength range of 150 to 400 nm according to the following formula (6):

$$\Delta\alpha \ (\lambda) = 1n \ (T_{bef}(\lambda)/T_{aft}(\lambda)) \tag{6},$$

wherein $\Delta\alpha$ ($\lambda$) is an ultraviolet-light-irradiation-induced absorption coefficient at a wavelength $\lambda$ nm (cm$^{-1}$),

$T_{bef}$ ($\lambda$) is an absorption coefficient before the irradiation of ultraviolet light at a wavelength $\lambda$ nm (%), and
$T_{aft}$ ($\lambda$) is an absorption coefficient after the irradiation of ultraviolet light at a wavelength $\lambda$ nm (%).

Then, absorption spectra obtained from the samples having no detected oxygen-deficit type defect were subjected to a curve fitting analysis using three Gaussian functions based on center wavelengths of 180 nm, 220 nm and 260 nm to calculate an absorption intensity $\Delta\alpha$ (180 nm) (cm$^{-1}$) in the 180 nm absorption band, and the concentration of NBOHC: $C_{NBOHC}$ (radicals/cm$^3$), was calculated according to the formula (1) and evaluated.

The evaluation result is shown in Table 1. The samples 10 and 11 correspond to Inventive Example, and the remaining samples correspond to Comparative Examples. In the sample 10, the concentration of NBOHC is $4.9 \times 10^{15}$/cm$^3$, and a transmittance at a wavelength of 172 nm after the irradiation with light of the xenon excimer light is 86.9 % which is deteriorated only slightly as compared to a transmittance of 88.9 % before the irradiation. Similarly, the sample 11 has a transmittance of 86.8 % after the irradiation which is deteriorated only slightly as compared to a transmittance of 89.0 % before the irradiation. In Comparative Examples, while the sample 6 has a relatively low concentration of NBOHC, it has a high concentration of OH group. The sample 1 has a high concentration of oxygen-deficit type defect. The samples 6 and 1 have a relatively large deterioration of transmittance, and the remaining Comparative Examples have a significantly large deterioration of transmittance.

Table 1

| Sample | Atmosphere in transparent-glass forming process | Condition of post-treatment | Concentration of OH group [ppm] | Concentration of hydrogen molecule [cm$^3$] | Concentration of oxygen-excess type defect [cm$^3$] |
|---|---|---|---|---|---|
| 1 | Cl$_2$/He = 2/98% 101 kPa | w/o post-treatment | < 0.1 | < 5 × 10$^{16}$ | < 1 × 10$^{16}$ |
| 2 | H$_2$ = 100% 101 kPa | w/o post-treatment | < 0.1 | 2 × 10$^{18}$ | < 1 × 10$^{16}$ |
| 3 | O$_2$/He = 10/90% 101 kPa | w/o post-treatment | 160 | < 5 × 10$^{16}$ | 2 × 10$^{17}$ |
| 4 | O$_2$/He = 5/95% 101 kPa | w/o post-treatment | 150 | < 5 × 10$^{16}$ | 8 × 10$^{16}$ |
| 5 | He = 100% 101 kPa | w/o post-treatment | 160 | < 5 × 10$^{16}$ | < 1 × 10$^{16}$ |
| 6 | He = 100% 100 Pa | w/o post-treatment | 8.3 | < 5 × 10$^{16}$ | < 1 × 10$^{16}$ |
| 7 | He = 100% 10 Pa | H$_2$ 100%, 1 atm 200 hr | 0.5 | 2 × 10$^{17}$ | < 1 × 10$^{16}$ |
| 8 | He = 100% 10 Pa | H$_2$ 100%, 10 atm 200 hr | 0.7 | 2 × 10$^{18}$ | < 1 × 10$^{16}$ |
| 9 | He = 100% 10 Pa | O$_2$ 100%, 1 atm 200 hr | 0.4 | < 5 × 10$^{16}$ | 2 × 10$^{18}$ |
| 10 | He = 100% 10 Pa | w/o post-treatment | 0.6 | < 5 × 10$^{16}$ | < 1 × 10$^{16}$ |
| 11 | SiF$_4$/He = 5/95% 101 kPa | w/o post-treatment | < 0.1 | < 5 × 10$^{16}$ | < 1 × 10$^{16}$ |

(Table 1 continued)

| Sample | Concentration of oxygen-deficit type defect [cm$^3$] | Transmittance at 172 nm before irradiation (%) | Transmittance at 172 nm after irradiation (%) | Concentration of NBOHC [cm$^3$] |
|---|---|---|---|---|
| 1 | 9 × 10$^{14}$ | 84.2 | 79.2 | un-evaluated |
| 2 | 2 × 10$^{14}$ | 81.8 | 23.3 | un-evaluated |
| 3 | < 1 × 10$^{14}$ | 88.0 | 56.4 | 9.6 × 10$^{16}$ |
| 4 | < 1 × 10$^{14}$ | 88.9 | 62.7 | 7.5 × 10$^{16}$ |
| 5 | < 1 × 10$^{14}$ | 88.8 | 68.3 | 5.6 × 10$^{16}$ |
| 6 | < 1 × 10$^{14}$ | 88.9 | 80.2 | 2.2 × 10$^{16}$ |
| 7 | < 1 × 10$^{14}$ | 88.8 | 57.9 | un-evaluated |
| 8 | < 1 × 10$^{14}$ | 89.0 | 21.4 | un-evaluated |
| 9 | < 1 × 10$^{14}$ | 88.3 | 75.1 | 3.5 × 10$^{16}$ |
| 10 | < 1 × 10$^{14}$ | 88.9 | 86.9 | 4.9 × 10$^{15}$ |
| 11 | < 1 × 10$^{14}$ | 89.0 | 86.8 | 5.4 × 10$^{15}$ |

**Claims**

1. A synthetic silica glass for use with light having a wavelength of 150 to 200 nm, which has an OH group at a concentration of less than 1 ppm, an oxygen-excess type defect at a concentration of $1 \times 10^{16}$ defects/cm$^3$ or less, a hydrogen molecule at a concentration of less than $1 \times 10^{17}$ molecules/cm$^3$, and a non-bridging oxygen radical at a concentration of $1 \times 10^{16}$ radicals/cm$^3$ or less in the state after the synthetic silica glass is irradiated with light of a xenon excimer lamp having an energy density of 10 mW/cm$^2$ and 3 kJ/cm$^2$.

2. A synthetic silica glass for use with light having a wavelength of 150 to 200 nm, which has an OH group at a concentration of less than 1 ppm, an oxygen-excess type defect at a concentration of $1 \times 10^{16}$ defects/cm$^3$ or less, a hydrogen molecule at a concentration of less than $1 \times 10^{17}$ molecules/cm$^3$, and a non-bridging oxygen radical at a concentration of $1 \times 10^{16}$ radicals/cm$^3$ or less in the state after the synthetic silica glass is irradiated with light of an $F_2$ laser by $10^7$ pulses at an energy density of 10 mJ/cm$^2$/pulse.

3. The synthetic silica glass as defined in claim 1 or 2, which has an oxygen-deficit type defect at a concentration of $1 \times 10^{14}$ defects/cm$^3$ or less.

**INTERNATIONAL SEARCH REPORT**

| International application No. |
|---|
| PCT/JP03/03759 |

A. CLASSIFICATION OF SUBJECT MATTER
   Int.Cl⁷ C03C3/06, C03B20/00

According to International Patent Classification (IPC) or to both national classification and IPC

B. FIELDS SEARCHED

Minimum documentation searched (classification system followed by classification symbols)
   Int.Cl⁷ C03C3/06, C03B20/00, C03B8/04

Documentation searched other than minimum documentation to the extent that such documents are included in the fields searched
   Jitsuyo Shinan Koho          1926-1996   Toroku Jitsuyo Shinan Koho   1994-2003
   Kokai Jitsuyo Shinan Koho    1971-2003   Jitsuyo Shinan Toroku Koho   1996-2003

Electronic data base consulted during the international search (name of data base and, where practicable, search terms used)
   JOIS

C. DOCUMENTS CONSIDERED TO BE RELEVANT

| Category* | Citation of document, with indication, where appropriate, of the relevant passages | Relevant to claim No. |
|---|---|---|
| Y | JP 2001-180962 A (Asahi Glass Co., Ltd.), 03 July, 2001 (03.07.01), Claims; Par. Nos. [0001], [0007], [0018], [0019], [0041] to [0044] (Family: none) | 1-3 |
| Y | JP 9-241030 A (SHIN-ETSU QUARTZ PRODUCTS CO., LTD.), 16 September, 1997 (16.09.97), Claims; Par. Nos. [0002], [0010] (Family: none) | 1-3 |
| Y | JP 2001-72428 A (Asahi Glass Co., Ltd.), 21 March, 2001 (21.03.01), Claims; Par. Nos. [0001], [0010] to [0012] | 1-3 |

☒ Further documents are listed in the continuation of Box C.    ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 25 June, 2003 (25.06.03) | 08 July, 2003 (08.07.03) |

| Name and mailing address of the ISA/ | Authorized officer |
|---|---|
| Japanese Patent Office | |
| Facsimile No. | Telephone No. |

Form PCT/ISA/210 (second sheet) (July 1998)

**INTERNATIONAL SEARCH REPORT**

| International application No. |
|---|
| PCT/JP03/03759 |

C (Continuation).   DOCUMENTS CONSIDERED TO BE RELEVANT

| Category* | Citation of document, with indication, where appropriate, of the relevant passages | Relevant to claim No. |
|---|---|---|
| Y | EP 1084995 A1   (HERAEUS QUARZGLAS GMBH & CO., KG), 21 March, 2001 (21.03.01), Claims; Par. Nos. [0020], [0025] to [0027]; Fig. 1 & JP 2001-89170 A Claims; Par. Nos. [0013], [0016], [0017]; Fig. 1 | 1-3 |
| Y | JP 2000-239040 A   (SHIN-ETSU QUARTZ PRODUCTS CO., LTD.), 05 September, 2000 (05.09.00), Claims; Par. Nos. [0013], [0017], [0018], [0039], [0049] (Family: none) | 1-3 |
| A | EP 870737 A1   (SHIN-ETSU QUARTZ PRODUCTS CO., LTD.), 14 October, 1998 (14.10.98), Claims & JP 10-338531 A Claims | 1-3 |
| A | JP 2001-311801 A   (Asahi Glass Co., Ltd.), 09 November, 2001 (09.11.01), Claims; Par. Nos. [0034] to [0036] (Family: none) | 1-3 |
| A | Hideo HOSONO, "Fusso Bunshi Excimer Laser (157nm) -yo Silica Glass", Oyo Butsuri, 10 April, 2000 (10.04.00), Vol.69, No.4, pages 415 to 419 | 1-3 |

Form PCT/ISA/210 (continuation of second sheet) (July 1998)